Europäisches Patentamt

European Patent Office

Office européen des brevets

(11) Publication number: **0 472 807 A2**

# EUROPEAN PATENT APPLICATION

(21) Application number: **91104128.3**

(22) Date of filing: **18.03.91**

(51) Int. Cl.⁵: **G01R 21/133**

(30) Priority: **30.08.90 US 575000**

(43) Date of publication of application:
**04.03.92 Bulletin 92/10**

(84) Designated Contracting States:
**DE FR GB IT**

(71) Applicant: **METRICOM, INC.**
**2605 Winchester Boulevard**
**Campbell, California 95008-5320(US)**

(72) Inventor: **Bradford, Curtis V.**
**350 Budd Avenue, No. E7**
**Campbell, California 95008(US)**

(74) Representative: **Dr. Fuchs, Dr. Luderschmidt**
**Dipl.-Phys. Seids, Dr. Mehler,Dipl.-Ing.-**
**Weiss**
**Abraham-Lincoln-Strasse 7, Postfach 4660**
**W-6200 Wiesbaden(DE)**

(54) **Method and apparatus for measuring volt-amps reactive power using synthesized voltage phase shift.**

(57) In the present invention, true volt-amperes reactive power is measured by sampling instantaneous voltage values of voltage and substantially simultaneously instantaneous values of current of an arbitrary waveform, multiplying the voltage samples by the discrete Hilbert transform (corrected by a sign inversion) to obtain voltage samples of all frequencies shifted by -90° over the bandwidth of the signal of interest and then multiplying this quadrature voltage sample by the corresponding current samples to obtain a true value for VARs, i.e., proportional to the instantaneous volt-amperes reactive power under all conditions. The sampling rate and the period of sampling determine the bandwidth and accuracy of the sampling technique. The invention can be implemented in software or in suitable hardware components capable of sampling and delaying the signal of interest.

EP 0 472 807 A2

## BACKGROUND OF THE INVENTION

This invention relates to the accurate measurement of voltage-ampere reactive power (VAR) and more particularly a method and apparatus for measuring VARs in a real world environment where the waveform of interest cannot be accurately approximated as a sinusoid.

Electrical utility system designs are based on the kilovolt-ampere (KVA) load to be served. The KVA load is regarded as the power expended under a given range of power factors. The power factor is defined as the ratio of current drawn by the load to the total current. The total current is defined in terms of kVARs. KVAR metering, or so-called phase-displaced metering, is an attempt to measure voltage and current in quadrature phase relationship to one another, under the assumption that the waveform is sinusoidal (i.e., has no harmonics). The VAR measurement derives from the unit of measurement of magnetizing volt-amperes and is an abbreviation for the phrase "volt-amperes reactive". It is conventionally defined as the voltage times the magnetizing current in amperes.

A theory of power measurement has been developed based on the use of VAR measurements, not all of which is technically correct. Moreover, traditional metering does not yield sufficiently-accurate VAR measurement to permit accurate system design and load management. Traditional measurement techniques involve measuring the current, measuring the voltage at the same time as the current is measured and then delaying the voltage measurements by a time equal to the phase difference of the fundamental frequency. As a consequence, a non-sinusoidal waveform is not accurately depicted and measured by conventional VAR measurement techniques, since a non-sinusoidal waveform contains harmonics of the fundamental which are not properly delayed. As a further consequence, traditional metering techniques may give wildly inaccurate VAR measurements, leading to inconsistent and misleading design and operation decisions, particularly where the voltage and current waveforms are subject to high distortion.

Traditional VAR calculation is described in the Handbook For Electricity Metering published by the Edison Electric Institute (8th Ed.) Chapter 9, pp. 173-196 (first Ed. 1912, latest Ed. 1981). Therein is described the traditional VAR metering techniques and theory of operation. It is of interest to note that the method of measurement of electrical qunatities is dependent upon the rate, the cost and the required accuracy. What is needed is a metering technique which is highly accurate under all loading conditions.

## SUMMARY OF THE INVENTION

According to the invention, true volt-amperes reactive power is measured by sampling instantaneous voltage values of voltage and simultaneously instantaneous values of current of an arbitrary waveform, multiplying the voltage samples by the discrete Hilbert transform (corrected by a sign inversion) to obtain voltage samples of all frequencies shifted by -90$^{\circ}$ over the bandwidth of the signal of interest and then multiplying this quadrature voltage sample by the corresponding current samples to obtain a true value for VARs, i.e., proportional to the instantaneous volt-amperes reactive power under all conditions. The sampling rate and the period of sampling determine the bandwidth and accuracy of the sampling technique. The invention can be implemented in software or in suitable hardware components capable of sampling and delaying the signal of interest.

The invention will be better understood by reference to the following detailed description in connection with the accompanying drawings.

## BRIEF DESCRIPTION OF THE DRAWINGS

Fig. 1 is a waveform diagram showing voltage as a function of time and current as a function of time for an ideal sinusoidal signal.

Fig. 2 is a block diagram of a meter according to the invention.

Fig. 3 is a schematic block diagram of an implementation of a meter in accordance with the invention.

## DESCRIPTION OF THE PREFERRED EMBODIMENTS

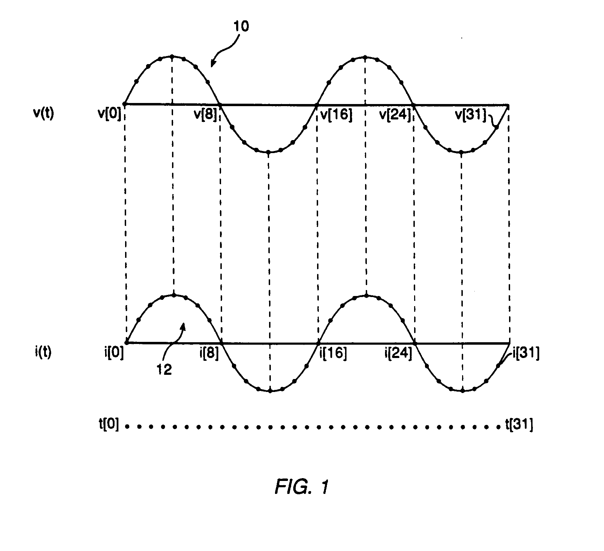

Referring to Fig. 1, there is shown a pair of waveforms 10, 12 representing voltage v(t) and current i(t) of an electric power system. In the depiction, the voltage and current are nearly sinusoidal and exhibit no phase difference therebetween. In reality, the waveforms are likely to be distorted, and there may be a phase difference between voltage and current. In accordance with the invention, the voltage and the current are each sampled substantially simultaneously. For example, there is sampling of each waveform at sample times t = 0 through t = 31 over a time of two periods of the fundamental frequency of the waveforms.

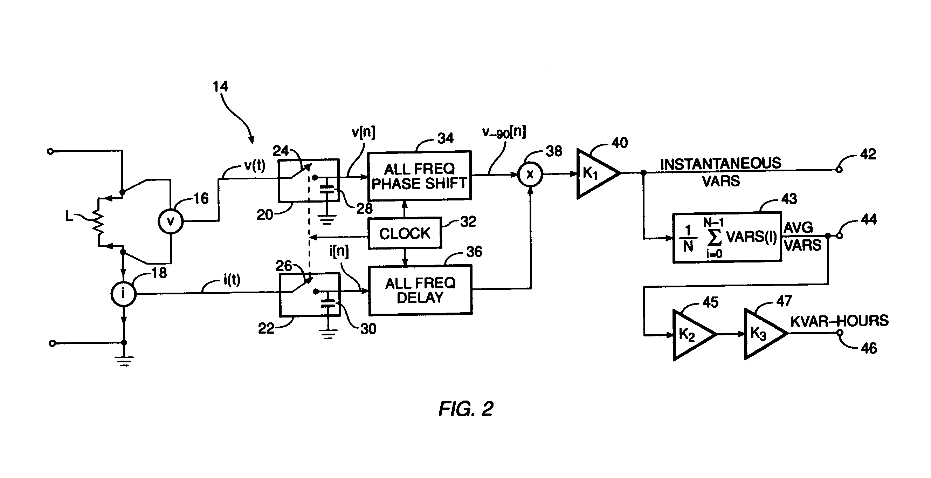

Referring to Fig. 2, there is shown a block diagram of a meter 14 according to the invention. The meter 14 includes a voltmeter 16 across a load of interest L and an ammeter 18 in series with the load L (or coupled in shunt across a known low resistance R in series with the load L) and adapted to measure instantaneous voltage and instantaneous current substantially continuously. The meter continuous outputs v(t) and i(t) are applied to sampling circuits 20 and 22, respectively, represented by switches 24, 26 and hold elements 28, 30. The switches are operated synchronously by a clock 32 so that the resultant samples v[n] and i[n] are synchronous and in phase.

The samples v[n] are applied to an all frequency phase shifter 34 according to the invention, as hereinafter explained, and the samples i[n] are time delayed as represented by a sample delay 36 to remain synchronous with the voltage samples v[n].

The output of the all frequency phase shifter 34 is the voltage samples v[n] delayed by 90 degrees, or $v_{-90}[n]$. The samples i[n] and $v_{-90}[n]$ are multiplied together in a multiplier 38, the product of which is scaled through an amplifier 40 by an appropriate gain factor $K_1$, the output of which is the instantaneous VARs 42. The VARs samples are summed over the sampling period N and scaled to obtain the average VARs 44 for the sampling period. KVAR-HOURS 46 is extracted from the instantaneous VARs 42 samples or from the average VARs by appropriate scaling, taking into account the frequency of sampling, the number of samples, the duration of the measurement period and by simply converting VARs to KVARs.

According to the invention, the all frequency phase shifter is a discrete Hilbert transform processor wherein the output is multiplied by negative 1. The coefficients for a simple multiplier realization of such a transform processor are given in Oppenheim and Schafer, Digital Signal Processing, (Prentice-Hall, 1975), page 360, Fig. 7.10. The coefficients are taken from the normalized impulse response of an ideal Hilbert transformer over an appropriate period corresponding to the sampling period before and after the instant of interest. In a specific embodiment, the period for sampling is one complete cycle plus one-half cycle before the cycle of interest and on-half cycle after the cycle of interest. The coefficients are the core of a ninety-degree phase shifter. Only odd values of samples are employed with the ninety-degree phase shifter, since the even values correspond to coefficients of value zero. As with any sampled-data system, aliasing of terms is a concern. Accordingly, the bandwidth of interest is selected to eliminate concerns about values aliased into the passband of interest.

The ninety-degree phase shifter is a realization of the following equation:

$$v_{-90}[n] = 3v[n-5] + 5v[n-3] + 15v[n-1] - 15v[n+1] - 5v[n+3] - 15v[n+5] \qquad (1)$$

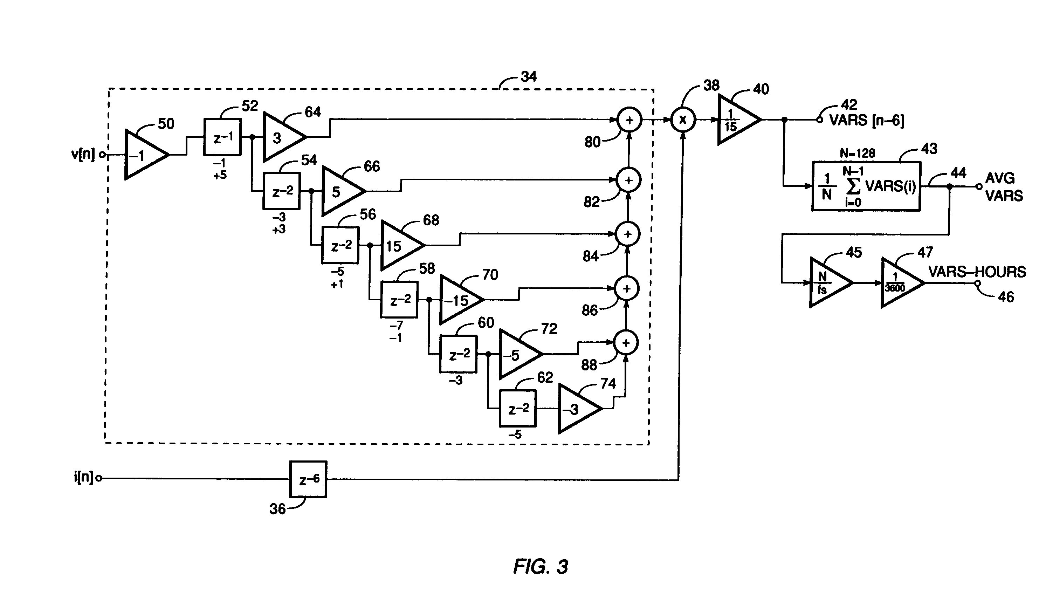

The foregoing equation is depicted in Fig. 3 as element 34 which comprises negative 1 multiplier 50, unit delay 52, dual unit delays 54, 56, 58, 60, 62, coefficient multipliers 64, 66, 68, 70, 72, 74, and parallel adders 80, 82, 84, 86, and 88. The all frequency delay 36 is a six unit delay such that multiplier 38 combines the multiplicand and multiplier at the midpoint of the delayed time interval of the nine degree phase shifter 34. The gain factor of the amplifier $K_1$ is 1/15 to compensate for the integer gain of the coefficient coefficient multipliers of element 34. The resultant output at 42 is an accurate representation (within sampling error) of instantaneous VARs delayed by six time units or six sample times. This result compares favorably with any other method of measuring VARs, and it exhibits the same level of accuracy for any waveform exhibiting distortion and having no substantial harmonics above one-half the sampling rate. Although the Hilbert transform is infinite, a representation containing six non-zero coefficients (or equivalently 13 zero and non-zero coefficients) provides adequate precision over the bandwidth of interest.

Other related values are readily derived from the instantaneous VARs measurements. For example, the average VARs for the measurement period, i.e., two seconds or N = 128 samples is given by:

$$\mathbf{VARS(avg)} = 1/N \sum_{i=0}^{N-1} \mathbf{VARS(i)} \qquad (2)$$

A suitable adder element 43 (Fig. 2 or Fig 3) performs this function. The VAR-HOURS is computed from VARS(avg) in accordance with the following relationship:

$$VAR\text{-}HOURS = VARS(avg) \ (N/f_s) \ (1/3600) \qquad (3)$$

where $f_s$ is the sampling frequency.

Elements 45 and 47 provide the appropriate scaling.

Appendix I, attached hereto and made a part hereof, is a listing of a software implementation of the method according to the invention as applied to a meter having an internal microprocessor capable of performing calculations on values representing sample voltage values and sample current values. This software routine is driven by the interrupts in the system used to acquire samples. The routine performs a portion of its calculation after each sampling in order to distribute the calculation burden of the processor. The result is a calculation which is based on a ninety-degree phase shift for all frequencies of interest. Also included in the routine are calculations of power and other quantities. In calculating power, a random delay is included in the data stream. This is equivalent to randomizing the data samples in order to assure that the steady-state waveform is accurately sampled.

While the invention has been particularly shown and described with reference to preferred embodiments thereof, it will be understood by those skilled in the art that the foregoing and other changes in the form and details may be made therein without departing from the spirit or scope of the invention.

# **Appendix I**

```
PAGINATE
TITLE "sample routine"
PAGEWIDTH 255
MODNAME(sample)

         -----------------------------------------------------------------------
sample:                        This routine is interupt driven off the TOC1-TOC3
                               interrupts.
                               It's only job is to sample the voltage and current.
                               It reads the results of the previous v and i samples,
                               and then starts a new conversion to be used next time.
                               This way the software does not have to wait around
                               for the a/d to finish its conversion.
                               It then jumps to the level 1 calculations.
         -----------------------------------------------------------------------

         %INCLUDE "meter.cfg"
         %INCLUDE "..\include\control.h"
         %INCLUDE "..\include\struc11.inc"
         %INCLUDE "..\include\kernel.inc"

         external        schedule(page0)
         external        scheduling(page0)
         external        tcnt_ext(page0)
         external        porty_mirror(page0)

         external        latest_v
         external        latest_i
         external        control
         external        sample_count
         external        start_time
         external        int_mask
         external        sample_period
         external        calc_1_struct_1
         external        calc_1_struct_2
         external        calc_1_struct_3
         external        LB_counter
         external        LBTime
         external        special_LBTime
         external        bat_voltage

         external        alternate_proc
         external        calculate_1

         public  sample_1_interrupt
         public  sample_2_interrupt
         public  sample_3_interrupt

         ;GLOBALs are mandatory ;PUBLICs are optional - for debugging
         GLOBAL  sample_1_interrupt,sample_2_interrupt,sample_3_interrupt,sample_
         GLOBAL  stored_adr1,stored_adr2,stored_adr3,stored_adr4,prev_pointer
         PUBLIC  sample

         SEG PAGE0

tored_adr1        ds        1
tored_adr2        ds        1
tored_adr3        ds        1
tored_adr4        ds        1
```

5

```
        SEG DATA

rev_pointer    ds      2                      ; used to store next business to do


        SEG CODE

ample PROC


    ------------ get voltage and current sample


ample_1_interrupt:

.ad_wait1:
        ldaa    ADCTL                  ; wait for previous conversion to finish
        bpl     ..ad_wait1             ; (just in case it didn't finish already

        ldx     #calc_1_struct_1       ; point to work area


    ------------ select both voltage and current to be sampled


        ldaa    porty_mirror
        anda    #06h                   ; leave other channels' hi/low bits
        oraa    control,x              ; select channel now
        staa    PORTY
        staa    porty_mirror

        ldaa    #OC1F                  ; load with flag to reset
        staa    TFLG1                  ; reset flag in control register


    ------------ compute next sample time


        ldd     TCNT                   ; get current value of free running coun
        addd    #SAMPLE_PERIOD         ; add sample period to value
%IF phases_installed EQ 3
        pshd
        ldd     LBTime
        .IF NZ,OR
                ldd     special_LBTime
        .IF NZ
                puld
                addd    #SAMPLE_PERIOD
        .ELSE
                puld
        .ENDIF
%ENDIF
        std     TOC1                   ; store into timer control register


    ------------ if sample count = 0 then read counter and store as start time
                 (this timestamps the first sample of the set of 32)


        .IF <ZERO,<sample_count,x>>
```

```
            ldd      LB_counter
            std      start_time,x
            ldd      LB_counter+2
            std      start_time+2,x
        .ENDIF


------------ start next a/d conversion


.start_ad:

            ldd      ADR1                 ; first store previous results
            std      stored_adr1
            ldd      ADR3
            std      stored_adr3

            ldaa     #10h                 ; start a/d conversion on inputs AN0-AN3
            staa     ADCTL


------------ jump to business


            ldy      prev_pointer

            xgdx                              ; exchange x and y
            xgdy
            xgdx
            sty      prev_pointer             ; store for next time


------------ if x = 0 or 1 then do alternate processing


            .IF <x,LS,#1>
                     jmp      alternate_proc
            .ENDIF


------------ else do sampling routine

------------ get results of last of a/d conversion


ample_process:

            ldaa     int_mask,x           ; turn of sample interrupt while in calc
            coma
            anda     TMSK1
            staa     TMSK1

            clrb                          ; clear b for use before carry created

            ldaa     stored_adr1          ; get first of 2 voltage samples
            adda     stored_adr3          ; add to second voltage sample
            rolb                          ; put carry bit into b reg

            staa     latest_v+1,x         ; store lower byte of voltage result
            stab     latest_v,x           ; store upper byte of voltage result
```

```
        ldaa    stored_adr2            ; get current sample
        staa    latest_i,x             ; store current result


  ; ------------ goto calculate 1 routine


        inc     scheduling             ; we may want to schedule later

        ENABLE                         ; turn interrupts back on

        jmp     calculate_1            ; continue with calc 1 routine

  sample ENDPROC

        end




$PAGINATE
$TITLE "calculate_1 routine"
$PAGEWIDTH 255
$MODNAME(calc1)


; ---------------------------------------------------------------------------
; calculate_1:             This routine is driven from the sample interrupts.
;                          This same routine runs for up to three channels.
;                          It takes the raw samples and validates the I sample
;                          and then performs the first level of calculations
;                          upon these samples.
;                          These level 1 calculations create sums using groups
;                          of 32 samples.  These samples have indexes 0 to 31.
;                          When these sums are full it notifies the level 2
;                          calculations task and exits to dispatcher.
;                          It produces 8 samples of instantaneous quadrature
;                          voltage and multiplies them by 8 instantaneous
;                          current samples to produce 8 instantaneous vars
;                          calculations. It then adds them to produce VAR_SUM.
; ---------------------------------------------------------------------------


        %INCLUDE "meter.cfg"
        %INCLUDE "..\include\control.h"
        %INCLUDE "..\include\kernel.inc"
        %INCLUDE "..\include\struc11.inc"

        external        schedule(page0)
        external        scheduling(page0)
        external        tcnt_ext(page0)

        external        FieldTest_Time
        external        LB_DeltaTime
        external        LB_RealDelta
        external        LB_counter
        external        LB_StartTime
        external        LB_LEDcounter
        external        LBTime
        external        Pulses_test
        external        special_LBTime

        external        calc_2_task1
        external        calc_2_task2
        external        calc_2_task3
        external        dispatch
        external        PostTask
        external        LB_Init

        external        MAX2_COUNT
        external        LED_ON

  $ALLPUBLIC

  HI_LIMIT      EQU     0FCH
  LOW_LIMIT     EQU     04H
  HI_RANGE      EQU     6

  CHANNEL_TEMP  EQU     00100000B
```

8

```
; ------------ work area offsets

POWER_SUM          EQU      00H
V_DC_SUM           EQU      POWER_SUM+3
I_DC_SUM           EQU      V_DC_SUM+2
V_RMS_SUM          EQU      I_DC_SUM+2
VAR_SUM            EQU      V_RMS_SUM+3
VR_RMS_SUM         EQU      VAR_SUM+3
I_RANGE            EQU      VR_RMS_SUM+4
START_TIME         EQU      I_RANGE+1
ORIG_START_TIME    EQU      START_TIME+4
FALSE_START        EQU      ORIG_START_TIME+4
power2_sum         equ      false_start+1
v_dc2_sum          equ      power2_sum+4
i_dc2_sum          equ      v_dc2_sum+3
v_rms2_sum         equ      i_dc2_sum+3
var2_sum           equ      v_rms2_sum+4
vr_rms2_sum        equ      var2_sum+4
sum2_count         equ      vr_rms2_sum+5
i_range0           equ      sum2_count+1
prev_start_time    equ      i_range0+1
done_flag          equ      prev_start_time+4
LB_tword           equ      done_flag+1
LB_float1          equ      LB_tword+6
LBdc_power         equ      LB_float1
LB_float2          equ      LB_float1+3
LB_float3          equ      LB_float2+3
LB_accum           equ      LB_float3+3
LB_count           equ      LB_accum+5
CALC_2_STRUCT_SIZE EQU      LB_count+2

IR_SAVE            EQU      FALSE_START+1
VR_SUM             EQU      IR_SAVE+8
SAMPLE_COUNT       EQU      VR_SUM+16
TEMP_STORE         EQU      SAMPLE_COUNT+1
SIGN_FLAG          EQU      TEMP_STORE+2
GAIN_TABLE         EQU      SIGN_FLAG+1
XFER_ADDRESS       EQU      GAIN_TABLE+2
LATEST_V           EQU      XFER_ADDRESS+2
LATEST_I           EQU      LATEST_V+2
CONTROL            EQU      LATEST_I+1
int_mask           equ      control+1
v_samples          equ      int_mask+1
;CALC_1_STRUCT_SIZE EQU     int_mask+1
CALC_1_STRUCT_SIZE equ      v_samples+64

power3_sum         equ      0
v_dc3_sum          equ      power3_sum+4
i_dc3_sum          equ      v_dc3_sum+3
v_rms3_sum         equ      i_dc3_sum+3
var3_sum           equ      v_rms3_sum+4
vr_rms3_sum        equ      var3_sum+4
i_range3           equ      vr_rms3_sum+5
sum3_count         equ      i_range3+1
delta_time         equ      sum3_count+1
calc_3_struct_size equ      delta_time+4


        SEG PAGE0
porty_mirror    ds       1
```

```
; ------------ define work areas


        SEG DATA

calc_1_struct_1 ds      calc_1_struct_size      ; level 1 work area
calc_2_struct_1 ds      calc_2_struct_size      ; level 2 work area
calc_3_struct_1 ds      calc_3_struct_size      ; level 3 work area

calc3_work_1    ds      calc_3_struct_size        ; temporary save area of level 3

$NOALLPUBLIC

        SEG CODE

        ;GLOBALs are mandatory ;PUBLICs are optional - for debugging
        GLOBAL  calculate_1,gain_table1,gain_table2,gain_table3
        GLOBAL  xfer1,xfer2,xfer3
        PUBLIC  count0,count_even,count3,count5,count7,count9,count11
        PUBLIC  count13,count15,count17,count19,count21,count23,count25
        PUBLIC  count27,count31,cont31,count_nop
        PUBLIC  exit_calc1,calc_1_jumps

calculate_1 PROC

; ------------ validate I sample


        ldaa    latest_i,x              ; load latest I sample


; ------------ if I sample is invalid then goto next higher I range       —


        .IF <a,HI,#HI_LIMIT>,OR        ; if I sample is greater than hi limit o
        .IF <a,LO,#LOW_LIMIT>          ; than lower limit then sample is invali
                ldab    i_range,x       ; load b with current I range

            .IF <b,NE,#HI_RANGE>        ; if I range is not max then increase
                                        ; to next higher range
                incb                    ; increase range

                stab    I_RANGE,x       ; store new range number

                ldy     gain_table,x
                aby                     ; index into lookup table

                ldaa    0,y             ; get new gain settings
                staa    control,x       ; store new value of control byt

                clr     sample_count,x  ; set sample count back to zero

                .IF <ZERO,<false_start,x>>      ; only set to false once
                        ldaa    #0ffh          ; set to false start
                        staa    false_start,x

                        ldd     start_time,x    ; save original start ti
```

```
                                        std     orig_start_time,x
                                        ldd     start_time+2,x
                                        std     orig_start_time+2,x
                        .ENDIF

                            jmp     exit_calc1      ; exit routine
                    .ENDIF
            .ENDIF


; ------------ jump to processing to be done based on sample index (0 - 31)

            ldy     #calc_1_jumps           ; point to top of jump table
            ldab    sample_count,x          ; get sample count
            lslb                            ; make 2 byte index
            aby
            ldy     0,y                     ; load address of code into y
            jmp     0,y                     ; jump to calc code


; ------------ come here if sample count = {0,2,4,...,30}

count_even:


; ------------ if sample count is 8 to 22 then store current I sample

            ldab    SAMPLE_COUNT,x          ; load present value of sample count

            .IF <b,GE,#8>,AND
            .IF <b,LE,#22>
                    subb    #8              ; make sample count into index for stora
                    lsrb

                    ldaa    LATEST_I,x      ; get current value of I

                    pshx                    ; save contents of x
                    abx                     ; add index
                    staa    IR_SAVE,x       ; save I sample for vars calculation
                    pulx                    ; recover value of x
            .ENDIF

            inc     SAMPLE_COUNT,x          ; increment sample count

            jmp     exit_calc1              ; exit routine


; ------------ come here if sample count = ( 3 )


count3:
            ldd     LATEST_V,x              ; load latest voltage sample

            lsld                            ; multiply by 3
            addd    LATEST_V,x

            std     VR_SUM,x                ; store into VR_SUM[0]
```

```
        inc     SAMPLE_COUNT,x          ; increment sample count

        jmp     exit_calc1              ; exit routine


; ------------- come here if sample count = ( 5 )


count5:
        ldd     LATEST_V,x              ; load latest voltage sample
        lsld                            ; multiply by 3
        addd    LATEST_V,x

        std     VR_SUM+2,x              ; store into VR_SUM[1]

        ldd     LATEST_V,x              ; multiply voltage sample by 5
        lsld
        lsld
        addd    LATEST_V,x

        addd    VR_SUM,x                ; add to VR_SUM[0]
        std     VR_SUM,x

        inc     SAMPLE_COUNT,x          ; increment sample count

        jmp     exit_calc1              ; exit routine


; ------------ come here if sample count = ( 7 )


count7:
        ldd     LATEST_V,x              ; multiply voltage sample by 3
        lsld
        addd    LATEST_V,x

        std     VR_SUM+4,x              ; store into VR_SUM[2]

        ldd     LATEST_V,x              ; multiply voltage sample by 5
        lsld
        lsld
        addd    LATEST_V,x

        addd    VR_SUM+2,x              ; add to VR_SUM[1]
        std     VR_SUM+2,x

        ldd     LATEST_V,x              ; multiply voltage sample by 15
        lsld
        lsld
        lsld
        lsld
        subd    LATEST_V,x

        addd    VR_SUM,x                ; add to VR_SUM[0]
        std     VR_SUM,x

        inc     SAMPLE_COUNT,x          ; increment sample count

        jmp     exit_calc1              ; exit routine
```

EP 0 472 807 A2

```
; ------------ come here if sample count = ( 9 )


count9:
        ldd     LATEST_V,x              ; multiply voltage sample by 3
        lsld
        addd    LATEST_V,x

        std     VR_SUM+6,x              ; store into VR_SUM[3]

        ldd     LATEST_V,x              ; multiply voltage sample by 5
        lsld
        lsld
        addd    LATEST_V,x

        addd    VR_SUM+4,x              ; add to VR_SUM[2]
        std     VR_SUM+4,x

        ldd     LATEST_V,x              ; multiply voltage sample by 15
        lsld
        lsld
        lsld
        lsld
        subd    LATEST_V,x

        std     TEMP_STORE,x            ; save this in temp storage
        addd    VR_SUM+2,x              ; add to VR_SUM[1]
        std     VR_SUM+2,x

        ldd     VR_SUM,x                ; subtract v * 15 from VR_SUM[0]
        subd    TEMP_STORE,x
        std     VR_SUM,x

        inc     SAMPLE_COUNT,x          ; increment sample count

        jmp     exit_calc1              ; exit routine


; ------------ come here if sample count = ( 11 )


count11:
        ldd     LATEST_V,x              ; multiply voltage sample by 3
        lsld
        addd    LATEST_V,x

        std     VR_SUM+8,x              ; store into VR_SUM[4]

        ldd     LATEST_V,x              ; multiply voltage sample by 5
        lsld
        lsld
        addd    LATEST_V,x
        std     TEMP_STORE,x            ; save in temporary storage

        addd    VR_SUM+6,x              ; add to VR_SUM[3]
        std     VR_SUM+6,x

        ldd     VR_SUM,x                ; subtract from VR_SUM[0]
        subd    TEMP_STORE,x
```

13

```
        std     VR_SUM,x

        ldd     LATEST_V,x              ; multiply voltage sample by 15
        lsld
        lsld
        lsld
        lsld
        subd    LATEST_V,x
        std     TEMP_STORE,x            ; save this in temp storage

        addd    VR_SUM+4,x             ; add to VR_SUM[2]
        std     VR_SUM+4,x

        ldd     VR_SUM+2,x             ; subtract from VR_SUM[1]
        subd    TEMP_STORE,x
        std     VR_SUM+2,x

        inc     SAMPLE_COUNT,x         ; increment sample count

        jmp     exit_calc1             ; exit routine


; ------------ come here if sample count = ( 13 )


count13:
        ldd     LATEST_V,x              ; multiply voltage sample by 3
        lsld
        addd    LATEST_V,x

        std     VR_SUM+10,x            ; store into VR_SUM[5]

        clr     SIGN_FLAG,x            ; clear sign flag

        ldd     VR_SUM,x               ; subtract from VR_SUM[0]
        subd    VR_SUM+10,x            ; this finishes VR_SUM[0]
        std     VR_SUM,x               ; store for debug


; ------------ if negative make positive for multiply


        .IF MI                         ; if result is negative then make positi
                coma                   ; make 2's complement
                comb
                addd    #1
                com     SIGN_FLAG,x    ; set flag to indicate minus result
        .ENDIF


; ------------ multiply VR_SUM[0] * IR_SAVE[0] and add to VAR_SUM


        DISABLE                        ; disable interupts for multiply

        std     X_WORD                 ; do multiply
        ldab    IR_SAVE,x              ; get the saved I sample for vars calc
        clra
        std     Y_WORD                 ; multiply by VR_SUM[0]
```

```
        .IF <PLUS,<SIGN_FLAG,x>>        ; check sign of VR_SUM

                ldd     Y_WORD          ; store product into VAR_SUM
                std     VAR_SUM+1,x
                ldaa    X_WORD+1
                staa    VAR_SUM,x
        .ELSE
                ldd     #0              ; store opposite of VAR_SUM
                subd    Y_WORD
                std     VAR_SUM+1,x
                ldaa    #0
                sbca    X_WORD+1
                staa    VAR_SUM,x
        .ENDIF

        ENABLE                          ; re-enable interupts

        ldd     LATEST_V,x              ; multiply voltage sample by 5
        lsld
        lsld
        addd    LATEST_V,x
        std     TEMP_STORE,x            ; save in temporary storage

        addd    VR_SUM+8,x              ; add to VR_SUM[4]
        std     VR_SUM+8,x

        ldd     VR_SUM+2,x              ; subtract from VR_SUM[1]
        subd    TEMP_STORE,x
        std     VR_SUM+2,x

        ldd     LATEST_V,x              ; multiply voltage sample by 15
        lsld
        lsld
        lsld
        lsld
        subd    LATEST_V,x
        std     TEMP_STORE,x            ; save this in temp storage

        addd    VR_SUM+6,x              ; add to VR_SUM[3]
        std     VR_SUM+6,x

        ldd     VR_SUM+4,x              ; subtract from VR_SUM[2]
        subd    TEMP_STORE,x
        std     VR_SUM+4,x

        inc     SAMPLE_COUNT,x          ; increment sample count

        jmp     exit_calc1              ; exit routine

; ------------ come here if sample count = ( 15 )

count15:
        ldd     LATEST_V,x              ; multiply voltage sample by 3
        lsld
        addd    LATEST_V,x

        std     VR_SUM+12,x             ; store into VR_SUM[6]
```

```
        clr     SIGN_FLAG,x             ; clear sign flag

        ldd     VR_SUM+2,x              ; subtract from VR_SUM[1]
        subd    VR_SUM+12,x             ; this finishes VR_SUM[1]
        std     VR_SUM+2,x             ; store for debug


; ------------ if negative make positive for multiply


        .IF MI                          ; if result is negative then make positi
            coma                        ; make 2's complement
            comb
            addd    #1
            com     SIGN_FLAG,x         ; set flag to indicate minus result
        .ENDIF


; ------------ multiply VR_SUM[1] * IR_SAVE[1] and add to VAR_SUM


        DISABLE                         ; disable interupts for multiply

        std     X_WORD
        ldab    IR_SAVE+1,x             ; get the saved I sample for vars calc
        clra
        std     Y_WORD                  ; multiply by VR_SUM[1]

        .IF <PLUS,<SIGN_FLAG,x>>        ; check sign of VR_SUM

            ldd     VAR_SUM+1,x         ; add product into VAR_SUM
            addd    Y_WORD
            std     VAR_SUM+1,x
            ldaa    VAR_SUM,x
            adca    X_WORD+1
            staa    VAR_SUM,x
        .ELSE
            ldd     VAR_SUM+1,x         ; subtract product from VAR_SUM
            subd    Y_WORD
            std     VAR_SUM+1,x
            ldaa    VAR_SUM,x
            sbca    X_WORD+1
            staa    VAR_SUM,x
        .ENDIF

        ENABLE                          ; re-enable interupts

        ldd     LATEST_V,x              ; multiply voltage sample by 5
        lsld
        lsld
        addd    LATEST_V,x
        std     TEMP_STORE,x            ; save in temporary storage

        addd    VR_SUM+10,x             ; add to VR_SUM[5]
        std     VR_SUM+10,x

        ldd     VR_SUM+4,x              ; subtract from VR_SUM[2]
        subd    TEMP_STORE,x
        std     VR_SUM+4,x
```

16

```
        ldd     LATEST_V,x              ; multiply voltage sample by 15
        lsld
        lsld
        lsld
        lsld
        subd    LATEST_V,x
        std     TEMP_STORE,x            ; save this in temp storage

        addd    VR_SUM+8,x              ; add to VR_SUM[4]
        std     VR_SUM+8,x

        ldd     VR_SUM+6,x              ; subtract from VR_SUM[3]
        subd    TEMP_STORE,x
        std     VR_SUM+6,x

        inc     SAMPLE_COUNT,x          ; increment sample count

        jmp     exit_calc1              ; exit routine


; ------------ come here if sample count = { 17 }


count17:
        ldd     LATEST_V,x              ; multiply voltage sample by 3
        lsld
        addd    LATEST_V,x

        std     VR_SUM+14,x             ; store into VR_SUM[7]

        clr     SIGN_FLAG,x             ; clear sign flag

        ldd     VR_SUM+4,x              ; subtract from VR_SUM[2]
        subd    VR_SUM+14,x             ; this finishes VR_SUM[2]
        std     VR_SUM+4,x              ; store for debug


; ------------ if negative make positive for multiply


        .IF MI                          ; if result is negative then make positi
                coma                    ; make 2's complement
                comb
                addd    #1
                com     SIGN_FLAG,x     ; set flag to indicate minus result
        .ENDIF


; ------------ multiply VR_SUM[2] * IR_SAVE[2] and add to VAR_SUM


        DISABLE                         ; disable interupts for multiply

        std     X_WORD
        ldab    IR_SAVE+2,x             ; get the saved I sample for vars calc
        clra
        std     Y_WORD                  ; multiply by VR_SUM[2]

        .IF <PLUS,<SIGN_FLAG,x>>        ; check sign of VR_SUM
```

```
            ldd     VAR_SUM+1,x         ; add product into VAR_SUM
            addd    Y_WORD
            std     VAR_SUM+1,x
            ldaa    VAR_SUM,x
            adca    X_WORD+1
            staa    VAR_SUM,x
    .ELSE
            ldd     VAR_SUM+1,x         ; subtract product from VAR_SUM
            subd    Y_WORD
            std     VAR_SUM+1,x
            ldaa    VAR_SUM,x
            sbca    X_WORD+1
            staa    VAR_SUM,x
    .ENDIF

    ENABLE                              ; re-enable interupts

    ldd     LATEST_V,x                  ; multiply voltage sample by 5
    lsld
    lsld
    addd    LATEST_V,x
    std     TEMP_STORE,x                ; save in temporary storage

    addd    VR_SUM+12,x                 ; add to VR_SUM[6]
    std     VR_SUM+12,x

    ldd     VR_SUM+6,x                  ; subtract from VR_SUM[3]
    subd    TEMP_STORE,x
    std     VR_SUM+6,x

    ldd     LATEST_V,x                  ; multiply voltage sample by 15
    lsld
    lsld
    lsld
    lsld
    subd    LATEST_V,x
    std     TEMP_STORE,x                ; save this in temp storage

    addd    VR_SUM+10,x                 ; add to VR_SUM[5]
    std     VR_SUM+10,x

    ldd     VR_SUM+8,x                  ; subtract from VR_SUM[4]
    subd    TEMP_STORE,x          .
    std     VR_SUM+8,x

    inc     SAMPLE_COUNT,x              ; increment sample count

    jmp     exit_calc1                  ; exit routine

; ------------ come here if sample count = ( 19 )


count19:
    ldd     LATEST_V,x                  ; multiply voltage sample by 3
    lsld
    addd    LATEST_V,x

    std     TEMP_STORE,x                ; store into temp storage
```

```
        clr     SIGN_FLAG,x             ; clear sign flag

        ldd     VR_SUM+6,x              ; subtract from VR_SUM[3]
        subd    TEMP_STORE,x            ; this finishes VR_SUM[3]
        std     VR_SUM+6,x              ; store for debug

; ------------ if negative then make positive for multiply

        .IF MI                         ; if result is negative then make positi
            coma                       ; make 2's complement
            comb
            addd    #1
            com     SIGN_FLAG,x         ; set flag to indicate minus result
        .ENDIF

; ------------ multiply VR_SUM[3] * IR_SAVE[3] and add to VAR_SUM

        DISABLE                        ; disable interupts for multiply

        std     X_WORD
        ldab    IR_SAVE+3,x            ; get the saved I sample for vars calc
        clra
        std     Y_WORD                 ; multiply by VR_SUM[3]

        .IF <PLUS,<SIGN_FLAG,x>>       ; check sign of VR_SUM

            ldd     VAR_SUM+1,x        ; add product into VAR_SUM
            addd    Y_WORD
            std     VAR_SUM+1,x
            ldaa    VAR_SUM,x
            adca    X_WORD+1
            staa    VAR_SUM,x
        .ELSE
            ldd     VAR_SUM+1,x        ; subtract product from VAR_SUM
            subd    Y_WORD
            std     VAR_SUM+1,x
            ldaa    VAR_SUM,x
            sbca    X_WORD+1
            staa    VAR_SUM,x
        .ENDIF

        ENABLE                         ; re-enable interupts

        ldd     LATEST_V,x            ; multiply voltage sample by 5
        lsld
        lsld
        addd    LATEST_V,x
        std     TEMP_STORE,x          ; save in temporary storage

        addd    VR_SUM+14,x           ; add to VR_SUM[7]
        std     VR_SUM+14,x

        ldd     VR_SUM+8,x            ; subtract from VR_SUM[4]
        subd    TEMP_STORE,x
        std     VR_SUM+8,x
```

```
        ldd     LATEST_V,x              ; multiply voltage sample by 15
        lsld
        lsld
        lsld
        lsld
        subd    LATEST_V,x
        std     TEMP_STORE,x            ; save this in temp storage

        addd    VR_SUM+12,x             ; add to VR_SUM[6]
        std     VR_SUM+12,x

        ldd     VR_SUM+10,x             ; subtract from VR_SUM[5]
        subd    TEMP_STORE,x
        std     VR_SUM+10,x

        inc     SAMPLE_COUNT,x          ; increment sample count

        jmp     exit_calc1              ; exit routine


; ------------ come here if sample count = ( 21 )


count21:
        ldd     LATEST_V,x              ; multiply voltage sample by 3
        lsld
        addd    LATEST_V,x

        std     TEMP_STORE,x            ; store into temp storage

        clr     SIGN_FLAG,x             ; clear sign flag

        ldd     VR_SUM+8,x              ; subtract from VR_SUM[4]
        subd    TEMP_STORE,x            ; this finishes VR_SUM[4]
        std     VR_SUM+8,x              ; store for debug


; ------------ if negative then make positive for multiply


        .IF MI                         ; if result is negative then make positi
             coma                      ; make 2's complement
             comb
             addd    #1
             com     SIGN_FLAG,x        ; set flag to indicate minus result
        .ENDIF


; ------------ multiply VR_SUM[4] * IR_SAVE[4] and add to VAR_SUM


        DISABLE                        ; disable interupts for multiply

        std     X_WORD
        ldab    IR_SAVE+4,x            ; get the saved I sample for vars calc
        clra
        std     Y_WORD                ; multiply by VR_SUM[4]

        .IF <PLUS,<SIGN_FLAG,x>>       ; check sign of VR_SUM
```

```
                 ldd       VAR_SUM+1,x      ; add product into VAR_SUM
                 addd      Y_WORD
                 std       VAR_SUM+1,x
                 ldaa      VAR_SUM,x
                 adca      X_WORD+1
                 staa      VAR_SUM,x
         .ELSE
                 ldd       VAR_SUM+1,x      ; subtract product from VAR_SUM
                 subd      Y_WORD
                 std       VAR_SUM+1,x
                 ldaa      VAR_SUM,x
                 sbca      X_WORD+1
                 staa      VAR_SUM,x
         .ENDIF

         ENABLE                             ; re-enable interupts

                 ldd       LATEST_V,x       ; multiply voltage sample by 5
                 lsld
                 lsld
                 addd      LATEST_V,x
                 std       TEMP_STORE,x     ; save in temporary storage

                 ldd       VR_SUM+10,x      ; subtract from VR_SUM[5]
                 subd      TEMP_STORE,x
                 std       VR_SUM+10,x

                 ldd       LATEST_V,x       ; multiply voltage sample by 15
                 lsld
                 lsld
                 lsld
                 lsld
                 subd      LATEST_V,x
                 std       TEMP_STORE,x     ; save this in temp storage

                 addd      VR_SUM+14,x      ; add to VR_SUM[7]
                 std       VR_SUM+14,x

                 ldd       VR_SUM+12,x      ; subtract from VR_SUM[6]
                 subd      TEMP_STORE,x
                 std       VR_SUM+12,x

                 inc       SAMPLE_COUNT,x   ; increment sample count

                 jmp       exit_calc1       ; exit routine


; ------------ come here if sample count = ( 23 )


count23:
                 ldd       LATEST_V,x       ; multiply voltage sample by 3
                 lsld
                 addd      LATEST_V,x

                 std       TEMP_STORE,x     ; store into temp storage

                 clr       SIGN_FLAG,x      ; clear sign flag

                 ldd       VR_SUM+10,x      ; subtract from VR_SUM[5]
```

```
        subd    TEMP_STORE,x            ; this finishes VR_SUM[5]
        std     VR_SUM+10,x             ; store for debug


; ------------ if negative then make positive for multiply


        .IF MI                          ; if result is negative then make positi
                coma                    ; make 2's complement
                comb
                addd    #1
                com     SIGN_FLAG,x     ; set flag to indicate minus result
        .ENDIF


; ------------ multiply VR_SUM[5] * IR_SAVE[5] and add to VAR_SUM


        DISABLE                         ; disable interupts for multiply

        std     X_WORD
        ldab    IR_SAVE+5,x             ; get the saved I sample for vars calc
        clra
        std     Y_WORD                  ; multiply by VR_SUM[5]

        .IF <PLUS,<SIGN_FLAG,x>>        ; check sign of VR_SUM

                ldd     VAR_SUM+1,x     ; add product into VAR_SUM
                addd    Y_WORD
                std     VAR_SUM+1,x
                ldaa    VAR_SUM,x
                adca    X_WORD+1
                staa    VAR_SUM,x
        .ELSE
                ldd     VAR_SUM+1,x     ; subtract product from VAR_SUM
                subd    Y_WORD
                std     VAR_SUM+1,x
                ldaa    VAR_SUM,x
                sbca    X_WORD+1
                staa    VAR_SUM,x
        .ENDIF

        ENABLE                          ; re-enable interupts

        ldd     LATEST_V,x              ; multiply voltage sample by 5
        lsld
        lsld
        addd    LATEST_V,x
        std     TEMP_STORE,x            ; save in temporary storage

        ldd     VR_SUM+12,x             ; subtract from VR_SUM[6]
        subd    TEMP_STORE,x
        std     VR_SUM+12,x

        ldd     LATEST_V,x              ; multiply voltage sample by 15
        lsld
        lsld
        lsld
        lsld
        subd    LATEST_V,x
```

```
        std     TEMP_STORE,x            ; save this in temp storage

        ldd     VR_SUM+14,x             ; subtract from VR_SUM[7]
        subd    TEMP_STORE,x
        std     VR_SUM+14,x

        inc     SAMPLE_COUNT,x          ; increment sample count

        jmp     exit_calc1              ; exit routine


; ------------ come here if sample count = ( 25 )


count25:
        ldd     LATEST_V,x              ; multiply voltage sample by 3
        lsld
        addd    LATEST_V,x

        std     TEMP_STORE,x            ; store into temp storage

        clr     SIGN_FLAG,x            ; clear sign flag

        ldd     VR_SUM+12,x             ; subtract from VR_SUM[6]
        subd    TEMP_STORE,x           ; this finishes VR_SUM[6]
        std     VR_SUM+12,x            ; store for debug


; ------------ if negative then make positive for multiply


        .IF MI                         ; if result is negative then make positi
                coma                   ; make 2's complement
                comb
                addd    #1
                com     SIGN_FLAG,x    ; set flag to indicate minus result
        .ENDIF


; ------------ multiply VR_SUM[6] * IR_SAVE[6] and add to VAR_SUM


        DISABLE                        ; disable interupts for multiply

        std     X_WORD
        ldab    IR_SAVE+6,x            ; get the saved I sample for vars calc
        clra
        std     Y_WORD                 ; multiply by VR_SUM[6]

        .IF <PLUS,<SIGN_FLAG,x>>        ; check sign of VR_SUM

                ldd     VAR_SUM+1,x    ; add product into VAR_SUM
                addd    Y_WORD
                std     VAR_SUM+1,x
                ldaa    VAR_SUM,x
                adca    X_WORD+1
                staa    VAR_SUM,x
        .ELSE
                ldd     VAR_SUM+1,x    ; subtract product from VAR_SUM
                subd    Y_WORD
```

```
                std       VAR_SUM+1,x
                ldaa      VAR_SUM,x
                sbca      X_WORD+1
                staa      VAR_SUM,x
                .ENDIF

                ENABLE                        ; re-enable interupts

                ldd       LATEST_V,x          ; multiply voltage sample by 5
                lsld
                lsld
                addd      LATEST_V,x
                std       TEMP_STORE,x        ; save in temporary storage

                ldd       VR_SUM+14,x         ; subtract from VR_SUM[7]
                subd      TEMP_STORE,x
                std       VR_SUM+14,x

                inc       SAMPLE_COUNT,x      ; increment sample count

                jmp       exit_calc1          ; exit routine


; ------------ come here if sample count = ( 27 )


count27:
                ldd       LATEST_V,x          ; multiply voltage sample by 3
                lsld
                addd      LATEST_V,x

                std       TEMP_STORE,x        ; store into temp storage

                clr       SIGN_FLAG,x         ; clear sign flag

                ldd       VR_SUM+14,x         ; subtract from VR_SUM[7]
                subd      TEMP_STORE,x        ; this finishes VR_SUM[7]
                std       VR_SUM+14,x         ; store for debug


; ------------ if negative then make positive for multiply


                .IF MI                        ; if result is negative then make positi
                coma                          ; make 2's complement
                comb
                addd      #1
                com       SIGN_FLAG,x         ; set flag to indicate minus result
                .ENDIF


; ------------ multiply VR_SUM[7] * IR_SAVE[7] and add to VAR_SUM


                DISABLE                       ; disable interupts for multiply

                std       X_WORD
                ldab      IR_SAVE+7,x         ; get the saved I sample for vars calc
                clra
                std       Y_WORD              ; multiply by VR_SUM[7]
```

24

```
        .IF <PLUS,<SIGN_FLAG,x>>        ; check sign of VR_SUM

                ldd     VAR_SUM+1,x     ; add product into VAR_SUM
                addd    Y_WORD
                std     VAR_SUM+1,x
                ldaa    VAR_SUM,x
                adca    X_WORD+1
                staa    VAR_SUM,x
        .ELSE
                ldd     VAR_SUM+1,x     ; subtract product from VAR_SUM
                subd    Y_WORD
                std     VAR_SUM+1,x
                ldaa    VAR_SUM,x
                sbca    X_WORD+1
                staa    VAR_SUM,x
        .ENDIF

        ENABLE                          ; re-enable interupts

        inc     SAMPLE_COUNT,x          ; increment sample count

        jmp     exit_calc1              ; exit routine


; ------------ come here if sample count = { 31 }


count31:

        ldy     XFER_ADDRESS,x          ; load address of code to run from here

        jmp     0,y


; ------------ come here if running channel 1 code


xfer1:
        ldab    TCNT+1          ; add randomness to channel's sampling
        clra
        addd    TOC1
        std     TOC1

        ldd     0,x
        std     calc_2_struct_1
        ldd     2,x
        std     calc_2_struct_1+2
        ldd     4,x
        std     calc_2_struct_1+4
        ldd     6,x
        std     calc_2_struct_1+6
        ldd     8,x
        std     calc_2_struct_1+8
        ldd     10,x
        std     calc_2_struct_1+10
        ldd     12,x
        std     calc_2_struct_1+12
        ldd     14,x
        std     calc_2_struct_1+14
```

```
        ldd     16,x
        std     calc_2_struct_1+16
        ldd     18,x
        std     calc_2_struct_1+18
        ldd     20,x
        std     calc_2_struct_1+20
        ldd     22,x
        std     calc_2_struct_1+22
        ldd     24,x
        std     calc_2_struct_1+24
        ldaa    26,x
        staa    calc_2_struct_1+26

        ldaa    #TCB_PEND               ; post pend
        ldab    #CALC_2_TASK1           ; post it to calc_2 task

        ldy     #calc_2_struct_1

cont31:
        pshx
        pshy
        jsr     PostTask                ; post sums ready to calc_2 task
        puly
        pulx


; ------------ determine if we should try a lower range

        .IF <ZERO,<false_start,x>>,AND          ; if we didn't false start
                ldaa    sum2_count,y
        .IF <a,EQ,#MAX2_COUNT-1>

                ldab    i_range,x
                .IF NZ
                        decb            ; increase range

                        stab    I_RANGE,x       ; store new range number

                        ldy     gain_table,x
                        aby                     ; index into lookup table

                        ldaa    0,y             ; get new gain settings
                        staa    control,x       ; store new value of control byt
                .ENDIF
        .ENDIF

        clr     SAMPLE_COUNT,x          ; reset sample count to zero

        clr     false_start,x

        clr     schedule                ; we want to schedule

        jmp     exit_calc1              ; exit routine


; ------------ come here when we are in a nop cycle


count_nop:
```

26

```
        inc     SAMPLE_COUNT,x          ; just increment sample count


; ------------ come here to exit calculation 1 routine

exit_calc1:
        DISABLE


; ------------ re-enable sampling interrupt for this channel


        ldaa    int_mask,x
        oraa    TMSK1
        staa    TMSK1

        dec     scheduling

        .IF  Z,AND
        .IF  <ZERO,schedule>

                jmp     dispatch        ; if we want and can schedule then do
        .ENDIF

        rti                             ; else just exit

; ------------ sample index jump table


calc_1_jumps:
                dw      count_even
                dw      count_nop
                dw      count_even
                dw      count3
                dw      count_even
                dw      count5
                dw      count_even
                dw      count7
                dw      count_even
                dw      count9
                dw      count_even
                dw      count11
                dw      count_even
                dw      count13
                dw      count_even
                dw      count15
                dw      count_even
                dw      count17
                dw      count_even
                dw      count19
                dw      count_even
                dw      count21
                dw      count_even
                dw      count23
                dw      count_even
                dw      count25
                dw      count_even
                dw      count27
                dw      count_even
```

27

```
            dw         count_nop
            dw         count_even
            dw         count31

gain_table1:
            db         01011000B              ; range 0, channel 1
            db         01011001B              ; range 1, channel 1
            db         01010000B              ; range 2, channel 1
            db         01010001B              ; range 3, channel 1
            db         01001000B              ; range 4, channel 1
            db         01001001B              ; range 5, channel 1
            db         01000000B              ; range 6, channel 1

gain_table2:
            db         01111000B              ; range 0, channel 2
            db         01111010B              ; range 1, channel 2
            db         01110000B              ; range 2, channel 2
            db         01110010B              ; range 3, channel 2
            db         01101000B              ; range 4, channel 2
            db         01101010B              ; range 5, channel 2
            db         01100000B              ; range 6, channel 2

gain_table3:
            db         00011000B              ; range 0, channel 3
            db         00011100B              ; range 1, channel 3
            db         00010000B              ; range 2, channel 3
            db         00010100B              ; range 3, channel 3
            db         00001000B              ; range 4, channel 3
            db         00001100B              ; range 5, channel 3
            db         00000000B              ; range 6, channel 3

calculate_1 ENDPROC

            end
```

# EP 0 472 807 A2

```
$PAGINATE
$TITLE "calculate_2 routine"
$PAGEWIDTH 255
$MODNAME(calc2)

; ----------------------------------------------------------------------
; calculate_2:        This routine is tasker driven and when sums are
;                     ready for processing it is notified using the TCB_PEND
;                     flag.
;                     It takes the VAR_SUM from the calculate_1 routine
;                     and combines them into larger sums until these sums
;                     are full.  It then copies them to the calculate 3
;                     locations and notifies the calculate 3 task.
;                     This routine's job is to create a suitable average
;                     vars sum.  This vars sum still requires scaling
;                     to produce true average vars and vars-hours.
;                     This scaling is done by calculate 3 task.
; ----------------------------------------------------------------------

        %INCLUDE "meter.cfg"
        %INCLUDE "..\include\control.h"
        %INCLUDE "..\include\kernel.inc"
        %INCLUDE "..\include\struc11.inc"
        %INCLUDE "..\include\macros.inc"

        external        RunningTcb(page0)
        external        tcnt_ext(page0)
        external        Tcb0

        external        gain_table1
        external        gain_table2
        external        gain_table3
        external        xfer1
        external        xfer2
        external        xfer3
        external        calc_1_struct_1
        external        calc_1_struct_2
        external        calc_1_struct_3
        external        calc_2_struct_1
        external        calc_2_struct_2
        external        calc_2_struct_3
        external        calc_3_struct_1
        external        calc_3_struct_2
        external        calc_3_struct_3
        external        conv_table

        external        power_sum
        external        v_dc_sum
        external        i_dc_sum
        external        v_rms_sum
        external        var_sum
        external        vr_rms_sum
        external        i_range
        external        start_time
        external        latest_v
        external        latest_i
        external        control
        external        xfer_address
        external        gain_table
```

29

```
          external          sample_count
          external          false_start
          external          int_mask
          external          orig_start_time

          external          power2_sum
          external          v_dc2_sum
          external          i_dc2_sum
          external          v_rms2_sum
          external          var2_sum
          external          vr_rms2_sum
          external          sum2_count
          external          i_range0
          external          prev_start_time
          external          done_flag

          external          LB_tword
          external          LB_float1
          external          LB_float2
          external          LB_float3
          external          LB_accum
          external          LB_count
          external          LBdc_power
          external          LB_Init
          external          DEF_KH
          external          DEF_KH_EXP
          external          power_minimum

          external          power3_sum
          external          v_dc3_sum
          external          i_dc3_sum
          external          v_rms3_sum
          external          var3_sum
          external          vr_rms3_sum
          external          i_range3
          external          sum3_count
          external          delta_time
          external          overrun_count

          external          calc_2_task1
          external          calc_2_task2
          external          calc_2_task3
          external          calc_3_task
          external          PendTask
          external          PostTask
          external          GetTaskID
          external          f_compare
          external          f_load
          external          f_store
          external          f_multiply
          external          f_divide
          external          f_add
          external          f_addext
          external          MAX2_COUNT

    $ALLPUBLIC

          SEG DATA

    sign_extend       ds        1
```

```
calc2_coin        ds       1          ; used to randomize error

LBTime            ds       2
special_LBTime    ds       2
LB_power1         ds       3          ; store average light blink power for side A
LB_power2         ds       3          ; store average light blink power for side B
LB_power3         ds       3          ; store average light blink power for side C
LB_powert         ds       3          ; store average light blink power of total
LB_DeltaTime      ds       6          ; current estimate of time between blinks
LB_RealDelta      ds       3
LB_counter        ds       4
LB_StartTime      ds       3
LB_LEDcounter     ds       1

$NOALLPUBLIC

        DEFSEG CODE2, class=CODE
        SEG CODE2

        ;GLOBALs are mandatory ;PUBLICs are optional - for debugging
        GLOBAL  calculate_2
        PUBLIC  calc_2_init,calc_2_loop,calc_2_loop2,calc_3_overrun
        PUBLIC  xfer_sums

calculate_2 PROC

calc_2_init:

; ------------ zero out variables in calc_2 and calc_3 structures


        ldaa    #0
        staa    sum2_count,x
        staa    done_flag,x
        staa    sum3_count,y

        staa    overrun_count          ; zero overrun count on every reset
        staa    overrun_count+1

        staa    calc2_coin             ; set coin to zero


; ------------ main routine's loop begins here


calc_2_loop:


; ------------ wait for sums

        pshx
        pshy
        ldab    #TCB_PEND
        ldy     #0
        jsr     PendTask
        puly
        pulx


; ------------ loop without pending
```

```
calc_2_loop2:

; ------------ if sum2_count = 0 then run this code

        .IF <ZERO,<sum2_count,x>>,NEAR
                ldd     VAR_SUM+1,x             ; load var sum
                std     VAR2_SUM+2,x
                ldaa    VAR_SUM,x
                staa    VAR2_SUM+1,x

                lsla                            ; put sign into carry
                ldaa    #0
                sbca    #0
                staa    VAR2_SUM,x

                ldaa    i_range,x               ; start with new i_range
                staa    i_range0,x


; ------------ calculate total time of entire level 2 var sum
                this will be used to calculate energy in level 3


        .IF <ZERO,<false_start,x>>,OR   ; if we didn't false start
        .IF <ZERO,calc2_coin>           ; or we randomly select this
                ldd     start_time+2,x          ; calculate delta time f
                subd    prev_start_time+2,x     ; last sums
                std     delta_time+2,y          ; store in calc_3 struct

                ldd     start_time,x
                sbcb    prev_start_time+1,x
                sbca    prev_start_time,x
                std     delta_time,y            ; store in calc_3 struct

                ldd     start_time,x            ; store start time into
                std     prev_start_time,x
                ldd     start_time+2,x
                std     prev_start_time+2,x

        .ELSE                                   ; if nonzero false start
                ldd     orig_start_time+2,x     ; calculate delta time f
                subd    prev_start_time+2,x     ; last sums
                std     delta_time+2,y          ; store in calc_3 struct

                ldd     orig_start_time,x
                sbcb    prev_start_time+1,x
                sbca    prev_start_time,x
                std     delta_time,y            ; store in calc_3 struct

                ldd     orig_start_time,x                ; store start ti
                std     prev_start_time,x
                ldd     orig_start_time+2,x
                std     prev_start_time+2,x
        .ENDIF

                com     calc2_coin              ; keep coin flipping
```

32

```
                pshx
                pshy

                ldaa    #TCB_PEND              ; post ready to calc_3
                ldab    #CALC_3_TASK
                jsr     PostTask

                puly
                pulx

                inc     sum2_count,x

                jmp     calc_2_loop

        .ENDIF


; ------------ if done_flag not zero or if we changed ranges then end sums

        .IF <NONZERO,<done_flag,x>>,OR
        .IF <NONZERO,<false_start,x>>
                jsr     xfer_sums             ; transfer to calc_3 sums
                clr     sum2_count,x          ; reset sum2 count
                clr     done_flag,x           ; reset done flag
                jmp     calc_2_loop2          ; loop without pending
        .ENDIF


; ------------ add new sums #1 to sums #2

        DISABLE                               ; prevent confusion of sign extend byte
        clr     sign_extend

        .IF <MINUS,<var_sum,x>>
                com     sign_extend
        .ENDIF

        ldd     VAR2_SUM+2,x                  ; add to var2 sum
        addd    VAR_SUM+1,x
        std     VAR2_SUM+2,x

        ldd     VAR2_SUM,x
        adcb    VAR_SUM,x
        adca    sign_extend
        std     VAR2_SUM,x
        ENABLE

        ldaa    sum2_count,x
        inca
        staa    sum2_count,x                  ; increment sum2 count


; ----------- if sum2_count = max then set done flag

        .IF <a,EQ,#MAX2_COUNT>
                bset    done_flag,x,0ffh
```

```
        .ENDIF

        jmp     calc_2_loop                 ; go wait for more sums


; ------------ this code converts the calc_2 sums into calc_3 sums


xfer_sums:
        .IF <NONZERO,<sum3_count,y>>
calc_3_overrun:
                ldd     overrun_count       ; increment overrun count
                addd    #1
                std     overrun_count
        .ENDIF

        ldd     var2_sum,x                  ; transfer var2 sum
        std     var3_sum,y
        ldd     var2_sum+2,x
        std     var3_sum+2,y

        ldaa    i_range0,x
        staa    i_range3,y

        ldaa    sum2_count,x                ; signal data ready togo
        staa    sum3_count,y

        rts

calculate_2     ENDPROC

        end
```

```
$PAGINATE
$TITLE "calculate_3 routine"
$PAGEWIDTH 255
$MODNAME(calc3)

; ----------------------------------------------------------------------
; calculate_3:            This routine is tasker driven and when sums are
;                         ready for processing it is notified using the TCB_PEND
;                         flag by the calculate 2 routine.
;                         It takes the sums from the calculate_2 routine
;                         and converts them into floating point values.
;                         It then multiplies them by scale factors and stores
;                         the results into the appropriate metering registers.
;                         It also takes the scaled average and multiplies it
;                         by the time over which the samples were taken to get
;                         the energy.  In this case it would be kilovolt-amp react
;                         hours.
; ----------------------------------------------------------------------


         %INCLUDE  "meter.cfg"
         %INCLUDE  "..\include\control.h"
         %INCLUDE  "..\include\kernel.inc"
         %INCLUDE  "..\include\struc11.inc"
         %INCLUDE  "..\include\regs.inc"

         external        RunningTcb(page0)
         external        tcnt_extra(page0)
         external        tcnt_ext(page0)

         external        gain_table1
         external        gain_table2
         external        gain_table3
         external        xfer1
         external        xfer2
         external        xfer3
         external        calc_1_struct_1
         external        calc_1_struct_2
         external        calc_1_struct_3
         external        calc_2_struct_1
         external        calc_2_struct_2
         external        calc_2_struct_3
         external        calc_3_struct_1
         external        calc_3_struct_2
         external        calc_3_struct_3
         external        calc3_work_1
         external        calc3_work_2
         external        calc3_work_3
         external        DemandStart
         external        DemandTest_status

         external        power3_sum
         external        v_dc3_sum
         external        i_dc3_sum
         external        v_rms3_sum
         external        var3_sum
         external        vr_rms3_sum
         external        i_range3
         external        sum3_count
         external        delta_time
```

35

```
external        timeslice

external        kwhrs_af_temp
external        kwhrs_ar_temp
external        kvhrs_af_temp
external        kvhrs_ar_temp

external        kwhrs_bf_temp
external        kwhrs_br_temp
external        kvhrs_bf_temp
external        kvhrs_br_temp

external        kwhrs_cf_temp
external        kwhrs_cr_temp
external        kvhrs_cf_temp
external        kvhrs_cr_temp

external        energy_crc
external        ee_energy_crc
external        energy_regs
external        temp_energy_regs
external        ee_energy_regs
external        conv_table
external        voltage_factors
external        ee_conv_table
external        ee_factor_crc
external        rom_conv_table
external        rom_voltage_factors
external        i_scaler
external        v_scaler
external        vscale_set_flag
external        iscale_set_flag
external        switchopen
external        switchtrip

external        calib_mode
external        calib_a_table
external        calib_b_table
external        calib_c_table
external        calib_table_size
external        calib_maxv_cnt
external        calib_a_cnt
external        calib_b_cnt
external        calib_c_cnt
external        calib_display

external        comp_to_peak4
external        crc_energy
external        PendTask
external        PostTask
external        crc
external        string_copy
external        string_zero
external        meter_test_init
external        DemandTest_Calc
external        dmultiply
external        make_mod_100k
external        WrEEprom

external         f_load
```

```
        external        f_store
        external        f_multiply
        external        f_divide
        external        f_add
        external        f_sqrt
        external        f_compare

        external        MAX2_COUNT
        external        METER_CALIBRATED
        external        LOST_KWHRS
        external        METER_UNGND

        external        sidea_range
        external        sideb_range
        external        sidec_range
        external        meter_status
        external        ee_meter_status
        external        calc_3_struct_size

$ALLPUBLIC


        SEG DATA

calc3_tword         ds      6
calc3_tword2        ds      6
calc3_farg1         ds      3
calc3_farg2         ds      3
calc3_farg3         ds      3
calc3_farg4         ds      3
calc3_farg5         ds      12              ; leave room for sqrt scratch

calc3_power         ds      4
calc3_voltage       ds      3
calc3_vars          ds      4
calc3_va            ds      4
calc3_reactive_v    ds      3
calc3_pf            ds      3
calc3_i             ds      3

calc3_energy        ds      4
calc3_reactive_e    ds      4

calc3_psflag        ds      1
calc3_varsflag      ds      1
calc3_overflow      ds      1
calc3_channel       ds      1
calc3_range         ds      1
calc3_status        ds      1               ; used to tell when valid number

energy_time         ds      3               ; timestamp of last total energy
                                      ; update using tcnt_ext word

calc3_v_sums   ds   (8+3)*phases_installed  ; sums and counts of voltages sq
calc3_i_sums   ds   (8+3)*phases_installed  ; sums and counts of currents sq

calc3_scaleflag ds    1
working_vscale  ds    6
working_pscale  ds    3
```

```
$NOALLPUBLIC

        DEFSEG CALC3,class=CODE
        SEG CALC3

        ;GLOBALs are mandatory ;PUBLICs are optional - for debugging
        GLOBAL  calculate_3,handle_cal, rom_set_flag
        PUBLIC  calc_3_init,calc_3_loop,convert_sums,compute_values
        PUBLIC  power_minimum,vars_minimum,calc_total_energy

calculate_3 PROC

; ------------ initialize routine


calc_3_init:


; ------------ main routine's loop begins here


calc_3_loop:


; ------------ wait for sums

        ldab    #TCB_PEND
        ldy     #0
        jsr     PendTask


; ------------ test the various calc_3 structures for nonzero sum3_counts


calc_3_loop2:
        DISABLE


; ------------ if structure for channel 1 is ready then process


        ldy     #calc_3_struct_1
        .IF <NONZERO,<sum3_count,y>>,NEAR
            ENABLE

            ldx     #calc3_work_1            ; copy sums to private work area
            ldab    #calc_3_struct_size
            jsr     string_copy

            clr     calc_3_struct_1+sum3_count       ; signal space available

            ldx     #calc3_work_1
            jsr     convert_sums            ; convert sums into AC floating

            ldaa    #0                      ; load channel-1 for indexing
            staa    calc3_channel

            ldaa    i_range3,x              ; load current range in convenie
            staa    calc3_range
```

```
                jsr       compute_values              ; compute real values

; ------------ add delta Kvar-hours of new sum to sum of total reactive energy

                ldy       #calc3_reactive_e
                ldx       #kvhrs_t
                jsr       add_delta_energy
        .ENDIF

        jmp       calc_3_loop              ; wait for more sums


; ---------------------------------------------------------------------------
; convert sums into floating point averages
; ---------------------------------------------------------------------------

convert_sums:


; ------------ compute unscaled average VARS by dividing sum by number of sample

        clr       calc3_varsflag           ; clear var sflag

        ldd       #0
        std       calc3_tword
        ldd       var3_sum+2,x
        std       calc3_tword+4
        ldd       var3_sum,x
        std       calc3_tword+2


; ------------ invert vars and record sign change if negative


        .IF MI
                ldd       #0
                subd      calc3_tword+4
                std       calc3_tword+4

                ldd       #0
                sbcb      calc3_tword+3
                sbca      calc3_tword+2
                std       calc3_tword+2

                ldd       #0
                sbcb      #0ffh
                sbca      #0ffh
                std       calc3_tword

                com       calc3_varsflag               ; set flag to negative
        .ENDIF

        pshx
        ldx       #calc3_tword
        ldy       #calc3_farg1
```

```
        jsr     f_load                          ; convert sum to floating point


; ------------ divide sum by number of instantaneous vars products in sum


        ldd     calc3_farg4                     ; put sum3 count into farg2
        std     calc3_farg2
        ldaa    calc3_farg4+2
        staa    calc3_farg2+2

        ldx     #calc3_farg1
        ldy     #calc3_vars                     ; store into calc3 vars

        jsr     f_divide                        ; get averge vars

        pulx

        rts

; --------------------------------------------------------------------------
; compute scaled values Kvars
; --------------------------------------------------------------------------


compute_values:

        pshx

; ------------ multiply vars by 1 / hilbert transform scale factor
; compute hilbert filter gain at 60 hz or w = 2*pi*60/sample_freq = 2*pi*60/960
; note hilbert filter gain = 15*2*sin(w) + 5*2*sin(3*w) + 3*2*sin(5*w)
; therefore gain = 26.2626 , so 1 / gain = .038077

        ldd     calc3_vars
        std     calc3_farg1
        ldaa    calc3_vars+2
        staa    calc3_farg1+2

        ldd     #9bf7h                  ; load 1 / gain in floating point
        std     calc3_farg2
        ldaa    #128-20
        staa    calc3_farg2+2

        ldx     #calc3_farg1
        ldy     #calc3_farg1

        jsr     f_multiply


; ------------ get scale factor for Kvars due to hardware


        ldy     #conv_table

        ldab    calc3_channel   ; first index by channel
        ldaa    #21             ; 7 ranges * 3 bytes / factor
        mul
        aby
```

```
            ldab    calc3_range         ; get index for power and var scale factors
            lslb                        ; multiply by 3
            addb    calc3_range
            aby

            ldd     0,y
            std     calc3_farg2             ; put vars scale factor in farg1
            ldaa    2,y
            staa    calc3_farg2+2

            ldx     #calc3_farg1
            ldy     #calc3_vars             ; store real scaled average Kvars

            jsr     f_multiply


; ------------ if Kvars is less than threshold then set to zero


            ldx     #calc3_vars
            ldy     #vars_minimum

            jsr     f_compare

            .IF CS                          ; if less than .005 Kvars then set to 0
            ldd     #0                      ; this prevents creep at 0 input
            std     calc3_vars
            staa    calc3_vars+2
            .ENDIF


; ------------ multiply Kvars by delta_time and conversion factor to get kilovar


            pulx
            pshx

            ldd     delta_time+2,x          ; convert delta_time to floating point
            std     calc3_tword+4
            ldd     delta_time,x
            std     calc3_tword+2
            ldd     #0
            std     calc3_tword

            ldx     #calc3_tword
            ldy     #calc3_farg2

            jsr     f_load

            ldd     calc3_vars
            std     calc3_farg1
            ldaa    calc3_vars+2
            staa    calc3_farg1+2

            ldx     #calc3_farg1
            ldy     #calc3_farg1

            jsr     f_multiply
```

```
; ------------- multiply by magic number to get kvar-hours
;                     this is due to delta time being in hardware ticks instead of hou

;note: constant = 1/7.2e+9 or 1.3888888888888e-10

        ldd     #39094
        std     calc3_farg2
        ldaa    #128-48
        staa    calc3_farg2+2

        ldx     #calc3_farg2
        ldy     #calc3_reactive_e

        jsr     f_multiply


; ------------- convert Kvar-hours back to fixed point


;note: we assume we always have less than 1 kvar-hour

        ldaa    calc3_reactive_e+2              ; make fraction have 4 bytes
        adda    #32
        staa    calc3_reactive_e+2

        ldx     #calc3_reactive_e
        ldy     #calc3_tword

        jsr     f_store

        ldd     calc3_tword+2
        std     calc3_reactive_e
        ldd     calc3_tword+4
        std     calc3_reactive_e+2


; ------------- convert average Kvars back to fixed point


        ldaa    calc3_vars+2          ; multiply by 2^16 to have 2 bytes of
        adda    #16                   ; fraction
        staa    calc3_vars+2

        ldx     #calc3_vars
        ldy     #calc3_tword

        jsr     f_store


; ------------- if vars was negative make calc3_dword minus before we store


        .IF <MINUS,calc3_varsflag>
                ldd     #0
                subd    calc3_tword+4
                std     calc3_tword+4

                ldd     #0
                sbcb    calc3_tword+3
```

42

```
                sbca      calc3_tword+2
                std       calc3_tword+2
        .ENDIF

        ldd       calc3_tword+2
        std       calc3_vars
        ldd       calc3_tword+4
        std       calc3_vars+2

        pulx

        rts


; --------------------------------------------------------------------
; minimum power and var levels detectable in KW and KVARS
; --------------------------------------------------------------------

vars_minimum:
                dw        0a3d7h              ; .005 KVARS
                db        128-23

calculate_3  ENDPROC


; --------------------------------------------------------------------
; Add new delta energy to total energy register.
; --------------------------------------------------------------------

add_delta_energy PROC
        ldd       5,x                    ; add new energy to temp register
        addd      2,y
        std       5,x
        ldd       3,x
        adcb      1,y
        adca      0,y
        std       3,x
        ldd       1,x
        adcb      #0
        adca      #0
        std       1,x
        ldaa      0,x
        adca      #0
        staa      0,x

        jsr       make_mod_100k    ; make modulus 100 thousand

        rts

add_delta_energy ENDPROC

        end
```

## Claims

1. A method for measuring volt-amps reactive power given non-sinusoidal wave form voltage and current, said method comprising the steps of:

    sampling substantially simultaneously instantaneous voltage and instantaneous current at a sampling frequency to produce voltage samples in current samples representative of a non-sinusoidal wave form;

    multiplying said voltage samples by a representation of a discrete Hilbert transform and by a constant of minus 1 in order to phase shift the voltage samples by $-90°$ for all frequencies less than one-half of a sampling frequency of said voltage samples to produce quadrature voltage samples;

    multiplying said quadrature voltage samples by corresponding ones of said current samples to produce a value proportional to instantaneous reactive power samples.

2. The method according to claim 1 further including the step of averaging said instantaneous reactive power samples to obtain a value proportional to average reactive power.

3. The method according to claim 1 wherein said instantaneous voltage and instantaneous current

43

sampling step comprises sampling over a period of at least one cycle of a fundamental frequency of interest.

4. The method according to claim 2 wherein said instantaneous voltage and instantaneous current sampling step comprises sampling over a period of at least one cycle of a fundamental frequency of interest and at least one quarter cycle prior to and at least one quarter cycle following a period of interest.

5. A method according to claim 1 further including the step of normalizing said value proportional to instantaneous reactive power to obtain a calibrated value for instantaneous reactive power.

6. A method for measuring volt-amps reactive power given non-sinusoidal wave form voltage and current, said method comprising the steps of:
   sampling substantially simultaneously instantaneous voltage and instantaneous current at a sampling frequency to produce voltage samples in current samples representative of a non-sinusoidal wave form over a period of at least one cycle of a fundamental frequency of interest and at least one quarter cycle prior to and at least one quarter cycle following a period of interest;
   multiplying said voltage samples by a representation of a discrete Hilbert transform and by a constant of minus 1 in order to phase shift the voltage samples by -90° for all frequencies less than one-half of a sampling frequency of said voltage samples to produce quadrature voltage samples;
   multiplying said quadrature voltage samples by corresponding ones of said current samples to produce a value proportional to instantaneous reactive power samples.

7. A meter for measuring volt-amps reactive power given non-sinusoidal wave form voltage in current comprising:
   means for sampling to substantially simultaneously instantaneous voltage and instantaneous current at a sampling frequency to produce voltage samples and current samples;
   means coupled to said sampling means for multiplying said voltage samples by a representation of a discrete Hilbert transform and by a constant of minus 1 in order to phase shift said voltage samples by -90° for all frequencies less than 1/2 a sampling frequency said instantaneous voltage and instantaneous current sampling to produce quadrature voltage samples and means coupled to said sampling means and said voltage multiplying means for multiplying said quadrature voltage samples by corresponding ones of said current samples to produce a value proportional to instantaneous reactive power samples.

8. The meter according to claim 7 furthering means coupled to said quadrature voltage multiplying means for averaging said instantaneous reactive power samples to obtain a value proportional to average reactive power.

9. Apparatus according to claim 8 further including a means coupled to receive said average reactive power value for multiplying by an inverse of a sampling frequency to produce a VAR-hours value.

FIG. 1

FIG. 2

FIG. 3

EP 0 472 807 A2